**Europäisches Patentamt**

**European Patent Office**

**Office européen des brevets**

(11) Veröffentlichungsnummer: **0 081 172**
**B1**

(12) **EUROPÄISCHE PATENTSCHRIFT**

(45) Veröffentlichungstag der Patentschrift:
**02.05.85**

(51) Int. Cl.⁴: **H 04 K 3/00, H 03 J 7/32**

(21) Anmeldenummer: **82110988.1**

(22) Anmeldetag: **27.11.82**

(54) **Funkempfangseinrichtung.**

(30) Priorität: **03.12.81 DE 3147815**

(43) Veröffentlichungstag der Anmeldung:
**15.06.83 Patentblatt 83/24**

(45) Bekanntmachung des Hinweises auf die Patenterteilung:
**02.05.85 Patentblatt 85/18**

(84) Benannte Vertragsstaaten:
**CH FR GB IT LI SE**

(56) Entgegenhaltungen:
**DE - A - 2 820 492**
**DE - C - 977 895**
**DE - C - 978 041**
**FR - A - 1 237 276**
**US - A - 3 449 749**
**US - A - 3 891 989**
**US - A - 4 062 020**

(73) Patentinhaber: **Rohde & Schwarz GmbH & Co. KG,**
**Mühldorfstrasse 15, D-8000 München 80 (DE)**

(72) Erfinder: **Knirsch, Herbert, Fünfkirchenerstrasse 40,**
**D-8057 Erding (DE)**

(74) Vertreter: **Graf, Walter, Sckellstrasse 1,**
**D-8000 München 80 (DE)**

## Beschreibung

Die Erfindung betrifft eine Funkempfangseinrichtung laut Oberbegriff des Hauptanspruches.

Eine Funkempfangseinrichtung dieser Art ist bekannt (FR-PS Nr. 1237276). Die Ausgangssignale der einzelnen Filter der Filterbank werden dabei jeweils über Detektoren und nachgeschaltete Tiefpassfilter den Abtastschaltern zugeführt, die ihrerseits mit der Bildschirmanzeigeeinrichtung verbunden sind. Mit dieser bekannten Einrichtung kann wie mit einem gewobbelten Panoramaempfänger, allerdings in Echtzeitdarstellung das gesamte Empfangsfrequenzspektrum auf dem Bildschirm dargestellt werden.

Filterbandempfänger dieser Art, bei denen ein grosses Frequenzband durch Filter in eine Vielzahl von aneinander anschliessenden Empfangskanälen aufgeteilt ist, werden auch zur schnellen Frequenzbestimmung benutzt („Microwave Journal", 1977, Januar, S. 29-33).

Zur drahtlosen Nachrichtenübermittlung werden neuerdings immer mehr Nachrichtensender verwendet, die nach einem vorher festgelegten Frequenzplan, der z. B. einer Pseudozufallsfolge entspricht, sehr schnell, beispielsweise jeweils nach 2 bis 100 ms, aperiodisch ihre Sendefrequenz elektronisch gesteuert wechseln. Es ist Aufgabe der Erfindung, eine Empfangseinrichtung zu schaffen, mit welcher die Signale solcher nach dem Frequenzsprungverfahren arbeitender Nachrichtensender auch ohne Kenntnis des Frequenzplanes empfangen, ausgewertet und weiterverarbeitet werden können.

Diese Aufgabe wird ausgehend von einer bekannten Funkempfangseinrichtung laut Oberbegriff des Hauptanspruches durch dessen kennzeichnende Merkmale gelöst. Vorteilhafte Weiterbildungen, insbesondere bezüglich der Weiterarbeitung des empfangenen Signals, ergeben sich aus den Unteransprüchen.

Mit einer erfindungsgemässen Empfangseinrichtung kann in bekannter Weise das gesamte Empfangsfrequenzspektrum eines Frequenzbandes, in welchem ein gesuchter Nachrichtensender arbeitet, in Echtzeitdarstellung auf dem Bildschirm dargestellt und durch einen Beobachter optisch ausgewertet werden. Ein Beobachter kann auf diese Weise diejenigen Frequenzkanäle erkennen, die einem nach dem Frequenzsprungverfahren arbeitenden Nachrichtensender zugeordnet sind, da die auf dem Bildschirm dargestellten Spektrumslinien, die von einem solchen Nachrichtensender stammen, nahezu gleichen Pegel besitzen und, da sie ja jeweils nur kurzzeitig vorhanden sind, eine geringe mittlere Helligkeit aufweisen. Darüber hinaus können vom Beobachter aber auch über die zusätzlichen, den Filterbankausgängen zugeordneten Schalter diejenigen Empfangskanäle ausgewählt werden, die als zum gleichen Nachrichtensender gehörig auf dem Bildschirm erkannt wurden, d. h. durch die zusätzlichen Schalter können diejenigen auf dem Bildschirm als nicht zum ausgewählten Nachrichtensender gehörigen Frequenzkanäle ausgeblendet werden, die nur eine weitere Verarbeitung der ausgewählten Nachrichtensendung des nach dem Frequenzsprungverfahren arbeitenden Nachrichtensenders stören würden. Durch die erfindungsgemässe Zusatzeinrichtung kann also über den Beobachter von Hand oder aber auch ggf. automatisch gesteuert durch einen entsprechenden Rechner aus den verschiedenen, an den Ausgängen der Filterbank zur Verfügung stehenden Nachrichtenbruchstücken das Signal zusammengesetzt und dann weiterverarbeitet werden. Stellt der Beobachter auf dem Bildschirm starke Spektrumslinien fest, die ständig mit relativ grosser Helligkeit vorhanden sind, so weiss er, dass es sich hierbei um konventionelle Sprechfunksender, beispielsweise um Rundfunksender oder Wetterdienstsender, handelt, die also eine Auswertung des nach dem Frequenzsprungverfahren arbeitenden Nachrichtensenders nur stören würden. Der Benutzer kann damit durch Öffnen derjenigen Schalter, die diesen die konventionellen Sprechfunksendungen empfangenen Empfangskanälen des Filterbankempfängers zugeordnet sind, diese nur störenden Sender ausblenden, so dass schliesslich nur noch diejenigen Empfangskanäle weiterverarbeitet werden, auf denen die Signale des nach dem Frequenzsprungverfahren arbeitenden Nachrichtensenders empfangen werden.

Die Weiterverarbeitung des so von Störungen durch festfrequente Sprechfunksendungen befreiten Nachrichtensignals kann auf verschiedene Weise erfolgen. Im einfachsten Fall könnte das zusammengesetzte Ausgangssignal über einen Demodulator demoduliert werden, also das empfangene Nachrichtensignal ausgewertet werden. Eine besonders vorteilhafte Art der Weiterverarbeitung des zusammengesetzten Ausgangssignals ist die unmittelbare Ansteuerung eines entsprechenden Störsenders. Störsender, die automatisch auf eine mittels eines Empfängers festgestellte Frequenz eingestellt werden, die also unmittelbar auf einer so festgestellten Empfangsfrequenz eines zu störenden Senders ein Störsignal aussenden, sind bekannt (US-PS Nr. 2567261, DE-PS Nrn. 977897, 978041). Die Anwendung einer erfindungsgemässen Funkempfangseinrichtung laut Hauptanspruch in Zusammenhang mit einem solchen, an sich bekannten Störsender ermöglicht es erstmals auf einfache Weise, auch Nachrichtensender, die nach dem Frequenzsprungverfahren arbeiten, auf wirksame Weise zu stören, da der Störsender automatisch auf die jeweiligen Empfangsfrequenzen, die in schneller Folge aperiodisch sich ändern, abgestimmt wird, also immer auf der richtigen Frequenz ein Störsignal aussendet. Ein solcher Störsender arbeitet sehr ökonomisch, da er auf den tatsächlich zu störenden Frequenzen jeweils seine volle Sendeleistung abstrahlen kann.

Eine andere Möglichkeit der Weiterverarbeitung des zusammengesetzten Nachrichtensignals ist die Ortung des ausgewählten Nachrichtensenders nach einem der bekannten Peilverfahren, indem beispielsweise zwei erfindungsgemässe Funkempfangseinrichtungen mit getrennten Empfangsantennen vorgesehen werden und die zusammengesetzten Ausgangssignale dieser beiden gesonderten Empfangseinrichtungen nach einem der bekannten Peilverfahren zur Richtungsbestimmung ausgewertet werden.

Die Erfindung wird im folgenden anhand einer schematischen Zeichnung an einem Ausführungsbeispiel näher erläutert.

Das von einem Nachrichtensender 1 auf schnell wechselnden Frequenzkanälen abgestrahlte Signal wird über eine Empfangsantenne 2 empfangen und in einem Filterbankempfänger 3 ausgewertet. Der Sender 1 sendet beispielsweise nach einem vorher festgelegten, nicht periodischen Frequenzplan sehr schnell auf unterschiedlichen Frequenzen. Er wechselt seine Sendefrequenz beispielsweise alle 2 bis 100 ms mit sehr schnellen Frequenzübergängen. Im Filterbankempfänger 3 wird das Hochfrequenzeingangssignal der Antenne 2 in einer ersten Überlagerungsstufe 4 in eine für die eigentliche Filterbank 5 geeignete Zwischenfrequenz umgesetzt. Die eigentliche Filterbank 5 besteht aus einer Vielzahl von Filtern K1, K2, K3,..., Kn, die beispielsweise in bekannter Weise als integrierte Schaltung unter Verwendung akustischer Oberflächenwellen (SAW, *Surface Acoustics Waves* oder als Keramikresonatoren) ausgeführt sind. Die Filterbank 5 kann beispielsweise aus einigen hundert solchen Filtern bestehen, jedes Filter kann beispielsweise 25 kHz Bandbreite besitzen, so dass ein relativ breites Frequenzband im MHz-Bereich gleichzeitig empfangen werden kann. Der Filterbankempfänger 3 ist über einen der ersten Überlagerungsstufe 4 zugeordneten Überlagerungsoszillator 6 in der Frequenz abstimmbar und so auf ausgewählte Frequenzbänder einstellbar. Die Bandbreite der frequenzmässig aneinander anschliessenden Filter ist vorzugsweise entsprechend dem zu erwartenden Frequenzkanalraster der zu überwachenden Nachrichtensender gewählt. Die Ausgänge der einzelnen Filter K1 bis Kn sind über Schalter S1, S2, S3,..., Sn jeweils mit Gleichrichtern 7 verbunden, denen Speicherkondensatoren 8 nachgeschaltet sind. Die Schalter S1 bis Sn können von einem Benutzer unabhängig voneinander ein- und ausgeschaltet werden. Die Ausgänge der Speicherkondensatoren 8 sind mit einem Abtastschalter 9 verbunden, der über einen Sägezahngenerator 10 synchron mit dem X-Ablenksystem einer Kathodenstrahlröhre 11 gesteuert ist. Der Ausgang 12 dieses Abtastschalters steht mit dem Y-Ablenksystem der Kathodenstrahlröhre 11 in Verbindung. Die Ausgänge der Schalter S1 bis Sn stehen ausserdem mit einem Summator 13 in Verbindung.

Sind alle Schalter S1 bis Sn geschlossen, so werden sämtliche über die Antenne 2 empfangenen und im Frequenzbereich der Filterbank liegenden Sender empfangen, das zwischenfrequente Ausgangssignal der Filter wird jeweils durch die Gleichrichter 7 gleichgerichtet und steht als Gleichspannung an den Speicherkondensatoren 8 zur Verfügung. Diese Gleichspannungspegel der Speicherkondensatoren 8 werden sehr schnell seriell über den Abtastschalter 9 synchron mit der X-Ablenkung der Kathodenstrahlröhre 11 abgetastet und so als Pegel spektrumartig auf dem Bildschirm dargestellt. Die jeweils vom gleichen Sender stammenden Pegel des Spektrums sind an ihrer nahezu gleichen Amplitude und, da sie jeweils nur kurz vorhanden sind, an ihrer geringen mittleren Helligkeit vom Benutzer erkennbar. Der Benutzer kann also über die Spektrumdarstellung erkennen, welche Empfangskanäle der Filterbank 3 Ausgangssignale von dem gleichen Nachrichtensender liefern, auf welchen Frequenzkanälen also der Nachrichtensender arbeitet. Der Benutzer braucht dann nur noch diejenigen Schalter S1 bis Sn, die nicht diesem ausgewählten Nachrichtensender zugehören, zu öffnen, und es steht ihm daher im Summator 13 das zusammengesetzte Nachrichtensignal zur Verfügung, das aus den Frequenzbruchstücken, die von den einzelnen Empfangskanälen K1 bis Kn empfangen wurden, zusammengesetzt ist. Die Schalter S1 bis Sn können natürlich auch in den Zuleitungen zu dem Summator 13 angeordnet sein, während die Dioden 7 unmittelbar mit den Ausgängen der Filterbank verbunden sind. Es wird dann immer das gesamte Spektrum des Frequenzbandes dargestellt, im Summator dagegen können ausgewählte Empfangskanäle ausgewertet und zusammengesetzt werden.

In der Praxis arbeiten Nachrichtensender nach dem Frequenzsprungverfahren nicht willkürlich in einem breiten Frequenzbereich, sondern meist nur auf einigen 10, 20 oder 30 speziell ausgewählten Kanälen, die für die Nachrichtenübermittlung sende- und empfangsseitig festliegen oder für einen bestimmten Einsatz befristet zwischen Sender und Empfänger vereinbart werden. Diese ausgewählten 10 bis 30 Kanäle werden dann in pseudozufälliger Reihenfolge immer wieder benutzt. Der Benutzer einer erfindungsgemässen Funkempfangseinrichtung kann im Sinne obiger Beschreibung also durch optische Beobachtung auf einfache Weise diese nach einem bestimmten Schlüssel ausgewählten Kanäle feststellen, und er braucht dann nur noch diejenigen Schalter zu schliessen, die diesen festgestellten Kanälen zugeordnet sind. Er kann dann lückenlos die jeweilige Nachricht weiterverarbeiten. Im allgemeinen wird es genügen, wenn der Benutzer all diejenigen Kanäle durch Öffnen der jeweiligen Schalter ausblendet, die mit Sicherheit die Auswertung einer gewünschten Nachricht nur stören würden, also beispielsweise solche Sender, die mit relativ grosser Leistung auf festen Frequenzen senden, also beispielsweise Rundfunksender. Dies kann der Beobachter leicht am Bildschirm feststellen, da solche Sender starke und helle Spektrumslinien darstellen. Der Benutzer kann durch Öffnen der Schalter diese die Auswertung nur störenden Sender ausblenden, er braucht in diesem Fall also nicht genau zu erkennen, auf welchen ausgewählten Kanälen die auszuwertende Nachricht tatsächlich ausgesendet wird, es genügt in diesem Fall nur die negative Auswahl der nur störenden Sender. Die erfindungsgemäss vorgesehenen Schalter ermöglichen also für die Weiterverarbeitung einer Nachricht sowohl die positive als auch die negative Auswahl von Kanälen, die vom Beobachter als zur Auswertung nützlich oder als zur Auswertung störend erkannt werden.

Das zusammengesetzte Ausgangssignal des Summators 13 in der Zwischenfrequenzlage kann, falls die verwendete Modulationsart des Nachrichtensenders dies sinnvoll erscheinen lässt, in einem Demodulator 14 ausgewertet werden. Das zusammengesetzte Ausgangssignal des Summators kann ausserdem zur Ansteuerung eines Störsenders benutzt werden, indem es beispielsweise mittels eines Mischers 15 und der Ausgangsfrequenz des Überlagerungsoszillators 6 des Filterbankempfängers wieder in die gleiche Hochfrequenzlage umgesetzt wird, die das über die Antenne 2 empfangene Ursprungssignal besitzt. Nach Verstärkung in einem Verstärker 16 kann dieses Störsignal über eine Antenne 17, ggf. moduliert, ausgesendet werden. Die Sendeantenne 17 besitzt vorzugsweise in Richtung der Empfangsantenne 2 eine Nullstelle. Dadurch und ggf. durch periodisch gesteuertes Abschalten wird eine Selbststeuerung des Systems vermieden.

Die Auswertung des Frequenzspektrums kann ggf. auch automatisch über einen Rechner 18 erfolgen, der nach entsprechender Digitalisierung des festgestellten Pegelwerte der einzelnen Empfangskanäle die Auswahl derjenigen Kanäle trifft, die dem gleichen Nachrichtensender zugeordnet sind, der also die Arbeit des Beobachters übernimmt und automatisch die zugehörigen Empfangskanäle auf den Summator schaltet.

Die erfindungsgemässe Einrichtung eignet sich auch sehr einfach zur gleichzeitigen Richtungsbestimmung des Nachrichtensenders 1, indem einfach der Empfängerzug zwischen Antenne 2 einschliesslich Filterbankempfänger 3 und Summator 13 doppelt aufgebaut wird. Die Ausgangssignale der beiden Summatoren können dann nach bekannten Peilverfahren zur Richtungsbestimmung ausgewertet werden. So können beispielsweise nach dem Interferrometer-Peilprinzip die Phasen der beiden Zwischenfrequenzausgangssignale der Summatoren miteinander verglichen werden und dadurch die Einfallsrichtung abgeleitet werden. Auch eine entsprechende Peilauswertung nach der Demodulation ist möglich, beispielsweise durch Auswertung der an den beiden, doppelt vorhandenen Demodulatoren 14 auftretenden Signale nach dem sog. TOA-Peilverfahren (*Time Of Arrival*-Peiler) durch Auswertung des Zeitunterschiedes der demodulierten Empfangssignale.

Die Umsetzung in eine ZF kann natürlich auch entfallen, die Filterbank könnte genauso gut unmittelbar auf das Eingangs-HF-Band ausgelegt sein.

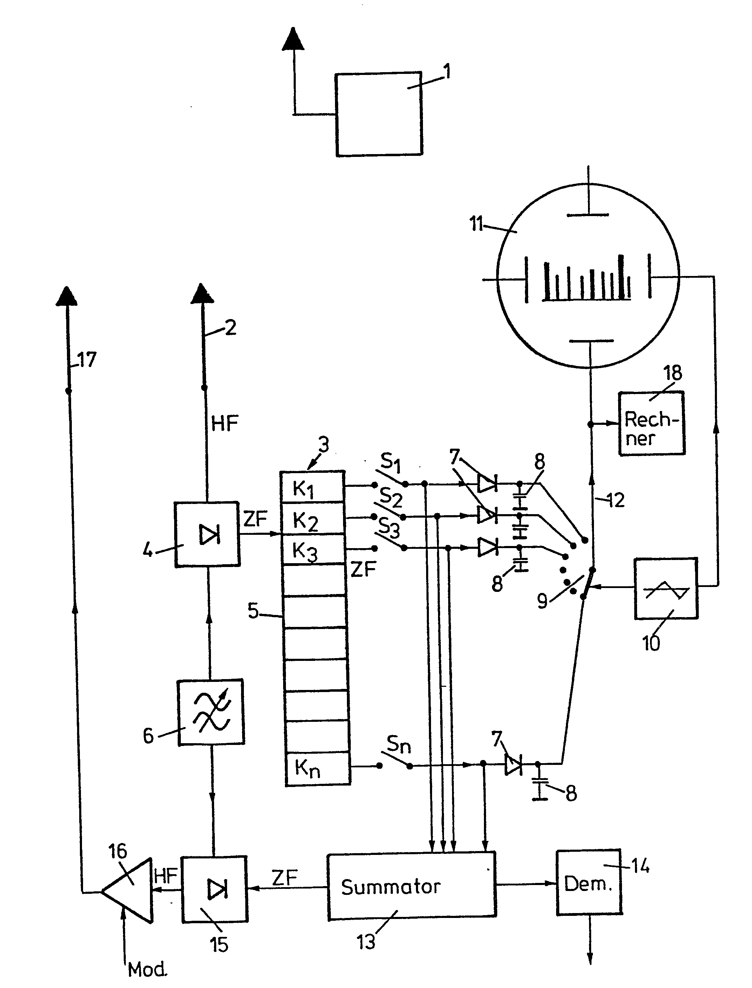

## Patentansprüche

1. Funkempfangseinrichtung mit einem Filterbankempfänger (3), dessen Filterausgänge zur Echtzeitdarstellung des Empfangsfrequenzspektrums auf einem Bildschirm (Kathodenstrahlröhre 11) über einen Abtastschalter (9) zyklisch abgetastet werden, dadurch gekennzeichnet, dass zur Signalverarbeitung von auf aperiodisch schnell wechselnden Frequenzen sendenden, d. h. nach dem Frequenzsprungverfahren arbeitenden Nachrichtensendern die Ausgänge der einzelnen Filter (K1 bis Kn) über gesonderte Schalter (S1 bis Sn) mit einer Signalverarbeitungsschaltung (13, 14, 15, 16) verbunden sind, so dass über diese Schalter diejenigen Frequenzen auswählbar sind, die auf dem Bildschirm (11) als zu ein und demselben Nachrichtensender gehörig erkannt werden.

2. Einrichtung nach Anspruch 1, dadurch gekennzeichnet, dass die Signalverarbeitungsschaltung einen Summator (13) umfasst, in welchem die Ausgangssignale der durch die Schalter (S1 bis Sn) ausgewählten Filter (K1 bis Kn) zu einem zusammenhängenden Signal zusammensetzbar sind.

3. Einrichtung nach Anspruch 2, dadurch gekennzeichnet, dass über das zusammengesetzte Ausgangssignal des Summators (13) in an sich bekannter Weise ein Störsender (15, 16, 17) angesteuert wird.

4. Einrichtung nach Anspruch 2, dadurch gekennzeichnet, dass das zusammengesetzte Ausgangssignal des Summators (13) einen Demodulator (14) zugeführt wird.

5. Einrichtung nach einem der vorhergehenden Ansprüche, dadurch gekennzeichnet, dass die abgetasteten Ausgangssignale der Filter (K1 bis Kn) nach entsprechender Digitalisierung in einem Rechner (18) automatisch ausgewertet werden und über diesen Rechner (18) die Schalter (S1 bis Sn) gesteuert sind.

6. Einrichtung nach einem oder mehreren der vorhergehenden Ansprüche, dadurch gekennzeichnet, dass zwei mit getrennten Empfangsantennen (2) verbundene Filterbankempfänger (3) mit zugehörigen Summatoren (13) vorgesehen sind und das zusammengesetzte Ausgangssignal der beiden Summatoren oder das demodulierte Ausgangssignal dieser Summatoren nach bekannten Peilverfahren zur Richtungsbestimmung des ausgewählten Nachrichtensenders (1) ausgewertet werden.

## Claims

1. Radio receiving device with a filter-bank receiver (3) whose filter outputs are cyclically tapped off by a sampling switch (9) for the purpose of real-time representation of the received frequency spectrum on a display screen (cathode ray tube 11), characterized in that for the purpose of processing the signals of transmitters sending with rapidly and aperiodically changing frequencies, i. e. employing frequency-hopping, the outputs of the individual filters (K1 to Kn) are connected *via* separate switches (S1 to Sn) with a signal-processing circuit (13, 14, 15, 16), so that by means of these switches those frequencies can be selected which are recognized on the display screen (11) as belonging to one and the same transmitter.

2. Device according to Claim 1, characterized in that the signal-processing circuit contains a summator (13) in which the output signals of the filters (K1 to Kn) selected by the switches (S1 to Sn) are combinable to a coherent signal.

3. Device according to Claim 2, characterized in that a jamming transmitter (15, 16, 17) is controlled in a *per se*-known manner by the combined output signal of the summator (13).

4. Device according to Claim 2, characterized in that the combined output signal of the summator (13) is applied to a demodulator (14).

5. Device according to one of the preceding claims, characterized in that the output signals of the filters (K1 to Kn) tapped off are after appropriate digitalization automatically evaluated in a computer (18) and the switches (S1 to Sn) are controlled by means of this computer (18).

6. Device according to one or more of the preceding claims, characterized in that two filter-bank receivers (3) connected to separate receiving antennas (2) are each provided with a summator (13) and the combined output signal of the two summators or the demodulated output signal of these summators are evaluated in accordance with known direction-finding methods for determining the direction of the selected transmitter (1).

**Revendications**

1. Appareil de réception radio avec un bloc filtrant dont les sorties de filtre pour l'indication des spectres des fréquences de réception sur un écran à tube cathodique (11) sont analysées par un interrupteur d'exploration cyclique (9), caractérisé en ce que, pour la mise en œuvre de signaux apériodiques à fréquence rapidement variable, c'est-à-dire après la discontinuité des fréquences travaillant comme émetteur de nouvelles, les sorties du filtre individuel (K1 à Kn) par des interrupteurs (S1 à Sn) sont reliées à un montage pour la mise en œuvre d'un signal (13, 14, 15, 16), de sorte que, par ces interrupteurs, les fréquences peuvent être choisies sur l'écran (11) ainsi qu'un seul et même émetteur de nouvelles.

2. Appareil suivant la revendication 1, caractérisé en ce que la mise en œuvre du montage de signal comprend un totalisateur (13) dans lequel les signaux de sortie du filtre (K1 à Kn) choisis par les interrupteurs (S1 à Sn) sont amenés à un signal cohérent qui peut être composé.

3. Appareil suivant la revendication 2, caractérisé en ce que par le signal de sortie composé du totalisateur (13) est désigné de façon connue en soi un émetteur perturbateur (15, 16, 17).

4. Appareil suivant la revendication 2, caractérisé en ce que le canal de sortie composé du totalisateur (13) est amené à un démodulateur (14).

5. Appareil suivant l'une des revendications précédentes, caractérisé en ce que les signaux de sortie réglés du filtre (K1 à Kn) après une numérisation correspondante dans un calculateur (18) sont évalués automatiquement, et en ce que ce calculateur (18) commande les interrupteurs (S1 à Sn).

6. Appareil suivant une ou plusieurs des revendications précédentes, caractérisé en ce que sont prévus deux récepteurs du bloc filtrant (3) reliés à des antennes réceptrices séparées (2) avec des totalisateurs (13), et que les signaux de sortie des deux totalisateurs ou le signal de sortie démodulé de ces totalisateurs ont été évalués après détermination du sens de l'émetteur de nouvelles (1) évalué.